Europäisches Patentamt

European Patent Office

Office européen des brevets

Numéro de publication: **0 291 038**
**A1**

## DEMANDE DE BREVET EUROPEEN

(21) Numéro de dépôt: 88107599.8

(22) Date de dépôt: **11.05.88**

(51) Int. Cl.⁴ **H05K 5/02**

(30) Priorité: **14.05.87 FR 8706783**

(43) Date de publication de la demande:
**17.11.88 Bulletin 88/46**

(84) Etats contractants désignés:
**BE DE ES FR GB IT LU NL SE**

(71) Demandeur: **VIBRACHOC, Société Anonyme dite:**
**Parc d'Activités de l'Eglantier C.E. 2804**
**Lisses**
**F-91028 Evry Cédex(FR)**

(72) Inventeur: **Pavie, Denis**
**10, rue Saint Exupéry**
**F-91610 Ballancourt sur Essonne(FR)**

(74) Mandataire: **Weinmiller, Jürgen et al**
**Lennéstrasse 9 Postfach 24**
**D-8133 Feldafing(DE)**

(54) **Dispositif assurant la tenue d'un boîtier d'équipements électroniques sur un plateau.**

(57) Dispositif assurant la tenue d'un boîtier d'équipements électroniques sur un plateau.

La présente invention concerne un dispositif assurant la tenue d'un boîtier (1) d'équipements électroniques sur un plateau (10) constitué d'un fond (11), d'une plaque-arrière verticale (12) munie de la partie mâle (15) d'un connecteur, et de deux flancs latéraux (13), dispositif comportant au moins un verrou (20) situé à l'avant du plateau et relié mécaniquement à la face avant (2) du boîtier (1), caractérisé en ce qu'il comporte un moyen de blocage latéral du boîtier et/ou un moyen de blocage longitudinal.

Application aux boîtiers d'équipements montés sur des plateaux d'avions.

FIG.1

## Dispositif assurant la tenue d'un boîtier d'équipements électroniques sur un plateau.

La présente invention concerne un dispositif assurant la tenue d'un boîtier d'équipements électroniques sur un plateau, ce plateau pouvant être par exemple, un plateau installé à bord d'un avion.

Un tel plateau est généralement constitué d'un fond muni d'un diaphragme central perforé assurant une ventilation du boîtier, d'une plaque-arrière verticale recevant la partie mâle d'un connecteur, et de deux flancs latéraux guidant le boîtier lors de sa mise en place ou de son extraction.

Le boîtier comporte à sa partie arrière, la partie femelle du connecteur, et à sa partie avant, une face munie d'une poignée. Comme la partie femelle du connecteur est munie d'aiguilles relativement fragiles, la mise en place du boîtier et son extraction doivent se faire de manière précise.

Afin d'éviter une détérioration des aiguilles, les dispositifs de l'art antérieur comportent généralement deux verrous reliés de manière permanente au plateau et articulés sur celui-ci afin de s'accrocher chacun à une patte solidaire de la face avant du boîtier. L'inclinaison donnée à ces verrous permet d'appliquer, en même temps qu'une composante longitudinale assurant la connexion, une composante verticale qui plaque le boîtier sur le fond du plateau. Une fois le boîtier mis en place, les verrous sont efficaces pour éviter le soulèvement du boîtier, mais en présence de niveaux de vibrations ou de chocs importants tels que ceux prévus dans les nouvelles spécifications définies par les utilisateurs, le boîtier peut osciller latéralement au niveau de sa face avant. Le connecteur sert alors de pivot, et sert également d'appui longitudinal pour le boîtier, ces deux fonctions étant préjudiciables à sa durée de vie.

Le dispositif de la présente invention a pour but d'assurer une immobilisation du boîtier par rapport au plateau, immobilisation latérale et/ou longitudinale, par des moyens autres que le connecteur, celui-ci n'assurant alors aucune fonction d'immobilisation.

Selon un premier mode de réalisation assurant un blocage latéral du boîtier, la présente invention a pour objet un dispositif assurant la tenue d'un boîtier d'équipements électroniques sur un plateau constitué d'un fond, d'une plaque-arrière verticale munie de la partie mâle d'un connecteur, et de deux flancs latéraux, dispositif comportant au moins un verrou situé à l'avant de plateau et relié mécaniquement à la face avant du boîtier, un moyen de blocage latéral du boîtier, ce moyen de blocage étant constitué d'un taquet solidaire du plateau et associé à au moins une rainure pratiquée sur la face avant du boîtier.

Selon une variante du premier mode de réalisation, le moyen de blocage est constitué d'au moins un doigt solidaire du plateau et associé à au moins un orifice pratiqué sur la face avant du boîtier, ce ou ces doigts assurant également un blocage vertical du boîtier.

Selon un deuxième mode de réalisation assurant un blocage longitudinal du boîtier, la présente invention a pour objet un dispositif assurant la tenue d'un boîtier d'équipements électroniques sur un plateau constitué d'un fond, d'une plaque-arrière verticale munie de la partie mâle d'un connecteur, et de deux flancs latéraux, dispositif comportant au moins un verrou situé à l'avant du plateau et relié mécaniquement à la face avant du boîtier, caractérisé en ce qu'il comporte un moyen de blocage longitudinal du boîtier, constitué par une mise en butée de la face avant du boîtier contre le plateau.

Ces deux modes de réalisation peuvent bien entendu être associés dans un même dispositif. Dans ce cas, le moyen de blocage latéral est constitué d'un taquet solidaire du plateau et associé à au moins une rainure pratiquée sur la face avant du boîtier, ou d'au moins un doigt solidaire du plateau et associé à au moins un orifice pratiqué sur la face avant du boîtier, ce ou ces doigts assurant également un blocage vertical du boîtier, et le moyen de blocage longitudinal du boîtier est constitué par une mise en butée de la face avant du boîtier contre le plateau.

Selon une amélioration du dispositif, applicable dans le cas d'un moyen de blocage latéral constitué d'au moins un doigt, le dispositif comporte en outre au moins un doigt solidaire du plateau et associé à un moins un orifice pratiqué sur la face arrière du boîtier, ce ou ces doigts assurant, avec l'aide des doigts avant, un blocage vertical total du boîtier.

Selon une autre amélioration du dispositif, applicable au deuxième mode de réalisation avec moyen de blocage longitudinal, le dispositif de l'invention comporte en outre un moyen d'absorption de jeux et d'efforts constitué d'une plaque en appui sur des moyens élastiques, ce moyen d'absorption pouvant être situé côté plaque arrière au côté face-arrière du boîtier.

Il est décrit ci-après, à titre d'exemple et en référence au dessins annexés, un dispositif selon l'invention.

La figure 1 représente, en perspective deux plateaux, l'un muni d'un boîtier, l'autre sans boîtier, et représente également le premier mode de réalisation du dispositif.

La figure 2 représente, en vue de côté, un plateau muni d'un boîtier, et représente également le deuxième mode de réalisation du dispositif.

La figure 3 montre une association des deux modes de réalisation dans laquelle le moyen de blocage latéral est constitué d'au moins un doigt au niveau de la face avant, le verrou étant alors modifié selon la figure 3A.

La figure 4 montre, vue de dessus, une amélioration du dispositif dans laquelle la face arrière du boîtier comporte également au moins un doigt.

La figure 5 montre un moyen d'absorption situé côté plaque-arrière du plateau.

La figure 6 montre un moyen d'absorption situé côté face arrière du boîtier.

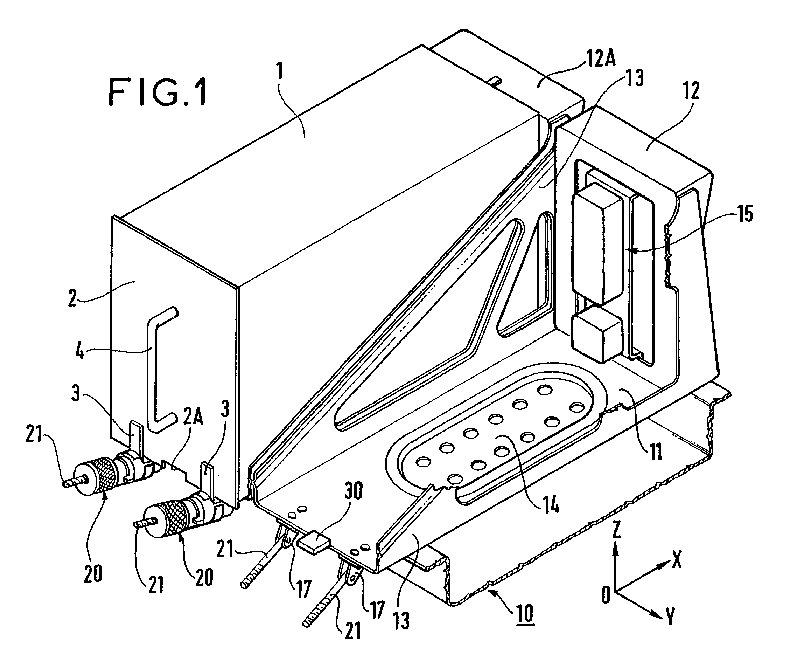

Dans la figure 1 sont représentés deux plateaux, l'un muni d'un boîtier 1 et l'autre non. Ceci permet de bien montrer la constitution d'un plateau. Le plateau 10 est constitué d'un fond 11 muni d'un diaphragme 14 permettant une ventilation du boîtier, d'une plaque arrière 12 sur laquelle est montée la partie mâle 15 d'un connecteur, et enfin de deux flancs latéraux 13 ajourés et de forme triangulaire.

A l'avant de ce plateau, et sous celui-ci, sont montées deux chapes 17 permettant chacune l'accrochage d'un axe 21 d'un verrou 20, chaque verrou étant relié à une patte 3 de la face avant 2 du boîtier lors de l'enfichage, du maintien et de l'extraction du boîtier.

On comprend donc que, pour mettre en place un boîtier, l'opérateur pose le boîtier sur le plateau et pousse celui-ci jusqu'à ce que la partie femelle du connecteur, munie d'aiguilles, vienne au contact de la partie mâle. Il accroche ensuite chaque verrou sur la patte 3 correspondante, et visse les verrous qui poussent le boîtier longitudinalement, selon l'axe OX + et jusqu'à ce que le connecteur soit correctement enfiché. L'angle que fait le verrou avec l'axe OX permet d'éviter un soulèvement de l'avant du plateau selon l'axe OZ + .

Selon l'invention, l'avant du plateau est muni d'un taquet 30 et la face avant 2 du boîtier 1 comporte une encoche 2A qui s'engage dans le taquet 30, ce qui empêche tout mouvement latéral du boîtier selon l'axe OY. Bien entendu, dans cette figure, le taquet 30 du plateau muni du boîtier, n'a pas été représenté afin de bien montrer la forme de l'encoche 2A.

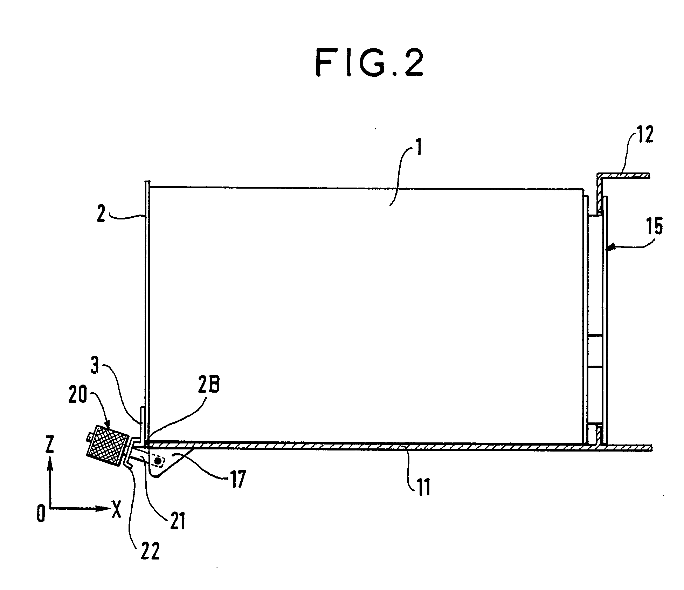

Dans la figure 2, montrant vue de côté le boîtier 1 posé sur le fond 11 d'un plateau, est représentée la face avant 2 du boîtier 1 prolongée, selon l'invention, par un bord 2B.

Chaque verrou 20, dont l'axe 21 est articulé sur une chape 17, est accroché, par l'intermédiaire d'une bague 22, à une patte 3 du boîtier.

Selon l'invention, les verrous bloquent, en fin de course, le bord 2B de la face avant du boîtier contre le fond 11 du plateau, ce qui empêche tout mouvement longitudinal du boîtier selon l'axe OX.

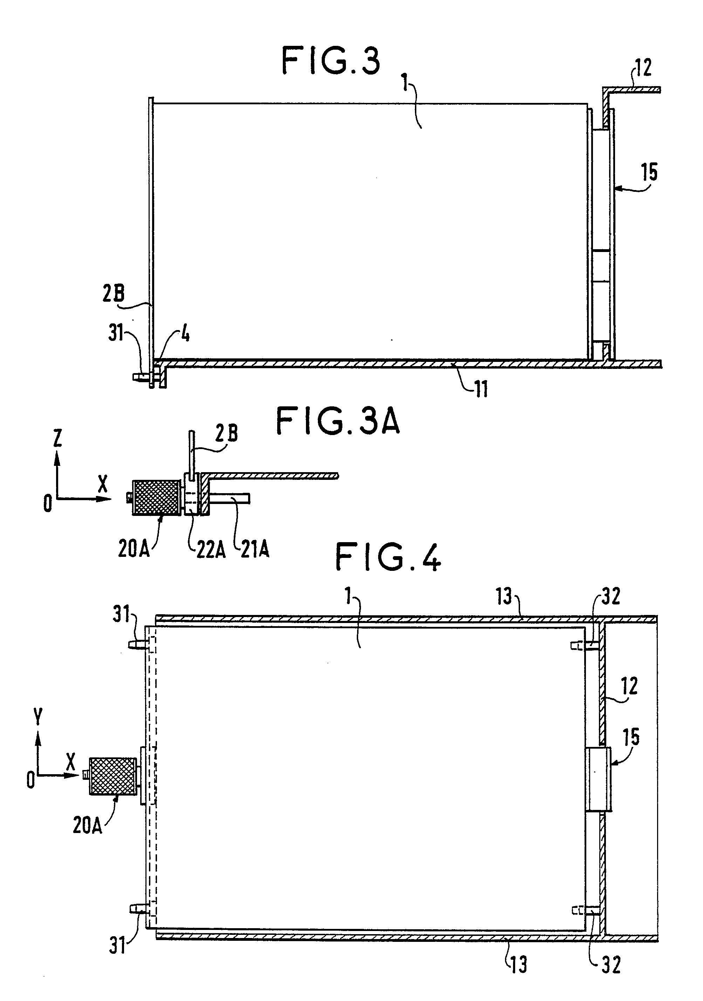

Dans la figure 3, un doigt 31 est solidarisé au plateau, et la face 2 du boîtier est percé d'un orifice correspondant. On comprend donc que ce doigt peut remplacer avantageusement un taquet tel que celui représenté en figure 1, car ce doigt assure non seulement un blocage latéral du boîtier selon l'axe OY, mais aussi vertical selon l'axe OZ + .

Le blocage vertical du boîtier permet de ne pas utiliser des verrous articulés assurant une composante verticale. Des verrous simples, tels que celui représenté dans la figure 3A, sont suffisants. Ce verrou simple 20A comporte un axe 21A non articulé par rapport au plateau, et une bague 22A dans laquelle s'engage le bord 2B de la face avant du boîtier. Bien entendu, le long de l'axe OY, il peut y avoir deux doigts symétriques par rapport à l'axe principal et un seul verrou central tel que cela est représenté dans la figure 4. Cette figure 3 montre une association d'un blocage latéral par l'intermédiaire d'au moins un doigt et un blocage longitudinal du boîtier par butée, selon l'axe OX + , mais bien entendu cette association n'est pas obligatoire.

La figure 4 montre, vue de dessus, un verrou central 20A, deux doigts avant 31 et également deux doigts arrière 32 solidaires de la plaque-arrière 12 et qui s'engagent dans des orifices pratiqués dans le boîtier. Le blocage vertical du boîtier est donc total.

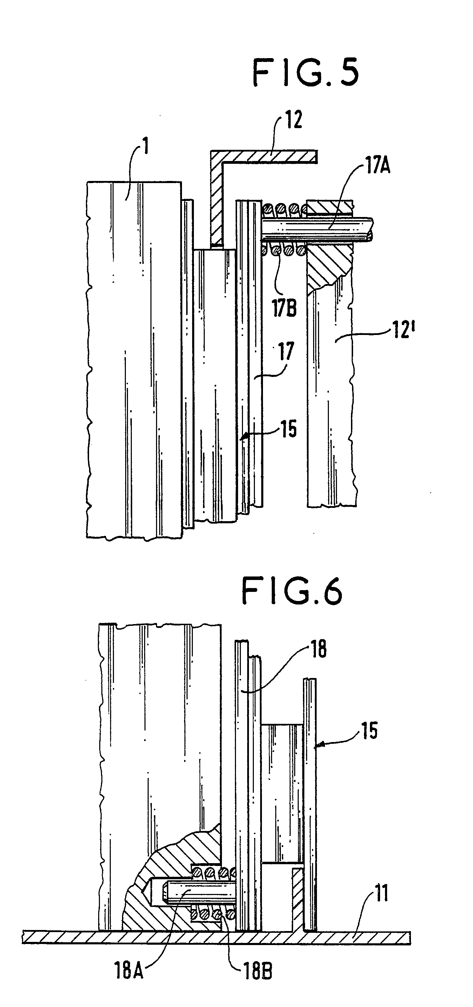

La figure 5 montre un moyen d'absorption de jeux et d'efforts, situé côté plaque-arrière 12 et constitué d'une entretoise 17 coulissant, par l'intermédiaire de guides 17A, dans des orifices d'une pièce 12' solidaire de la plaque arrière 12. Des ressorts 17B sont interposés au niveau de chaque guide, entre l'entretoise 17 et la pièce fixe 12'. Lors de l'enfichage du boîtier, la plaque 15 vient en appui sur l'entretoise 17, les ressorts 17B s'opposant au déplacement de l'ensemble plaque-entretoise, donc du boîtier selon l'axe OX + .

La figure 6 montre un moyen d'absorption équivalent, mais situé côté boîtier. Ce moyen est constitué d'une plaque 18 fixe munie de guides 18A sur lesquels coulisse le boîtier, des ressorts 18B étant interposés entre le boîtier et la plaque 18.

Lors de l'enfichage du boîtier, celui-ci s'appuie sur les ressorts 18B et ceux-ci s'opposent au déplacement du boîtier selon l'axe OX + .

**Revendications**

1/ Dispositif assurant la tenue d'un boîtier (1) d'équipements électroniques sur un plateau (10) constitué d'un fond (11), d'une plaque-arrière verticale (12) munie de la partie mâle (15) d'un connecteur, et de deux flancs latéraux (13), dispositif comportant au moins un verrou (20) situé à l'avant du plateau et relié mécaniquement à la face avant (2) du boîtier (1), un moyen de blocage latéral du boîtier, caractérisé en ce que le moyen de blocage est constitué d'au moins un taquet (30) solidaire du plateau (10) et associé à au moins une rainure (2A) pratiquée sur la face avant (2) du boîtier.

2/ Dispositif assurant la tenue d'un boîtier (1) d'équipements électroniques sur un plateau (10) constitué d'un fond (11), d'une plaque-arrière verticale (12) munie de la partie mâle (15) d'un connecteur, et de deux flancs latéraux (13), dispositif comportant au moins un verrou (20) situé à l'avant du plateau et relié mécaniquement à la face avant (2) du boîtier (1), un moyen de blocage latéral du boîtier, caractérisé en ce que le moyen de blocage est constitué d'au moins un doigt (31) solidaire du plateau et associé à au moins un orifice pratiqué sur la face avant (2) du boîtier, ce ou ces doigts assurant également un blocage vertical du boîtier.

3/ Dispositif assurant la tenue d'un boîtier (1) d'équipements électroniques sur un plateau (10) constitué d'un fond (11), d'une plaque-arrière verticale (12) munie de la partie mâle (15) d'un connecteur, et de deux flancs latéraux (13), dispositif comportant au moins un verrou situé (20) à l'avant du plateau et relié mécaniquement à la face avant (2) du boîtier (1), caractérisé en ce qu'il comporte un moyen de blocage longitudinal du boîtier, constitué par une mise en butée de la face avant du boîtier contre le plateau.

4/ Dispositif selon la revendication 3, caractérisé en ce qu'il comporte un moyen de blocage latéral du boîtier constitué d'au moins un taquet (30) solidaire du plateau et associé à une rainure (2A) pratiquée sur la face avant du boîtier.

5/ Dispositif selon la revendication 3, caractérisé en ce qu'il comporte un moyen de blocage latéral du boîtier constitué d'au moins un doigt (21) solidaire du plateau et associé à au moins un orifice pratiqué sur la face avant du boîtier, ce ou ces doigts assurant également un blocage vertical du boîtier.

6/ Dispositif selon l'une des revendications 2 ou 5, caractérisé en ce qu'il comporte au moins un doigt (32) solidaire du plateau et associé à au moins un orifice pratiqué sur la face arrière du boîtier, ce ou ces doigts assurant un blocage vertical du boîtier.

7/ Dispositif selon l'une des revendications 3 à 6, caractérisé en ce qu'il comporte un moyen d'absorption de jeux et d'efforts comportant une plaque (17, 18) en appui sur des moyens élastiques (17B, 18B).

8/ Dispositif selon la revendication 7, caractérisé en ce que le moyen d'absorption est situé côté plaque-arrière du plateau.

9/ Dispositif selon la revendication 7, caractérisé en ce que le moyen d'absorption est situé côté face arrière du boîtier.

FIG.1

0 291 038

# FIG.2

# FIG.3

# FIG.3A

# FIG.4

# FIG.5

# FIG.6

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-1 079 366 (SMITHS INDUSTRIES LTD) * Page 3, lignes 95-112 * --- | 1-3 | H 05 K 5/02 |
| A | US-A-4 361 372 (MAJKRZAK et al.) * Colonne 4, lignes 1-9 * --- | 1-3 | |
| A | US-A-4 236 190 (HOLLINGSEAD et al.) --- | | |
| A | US-A-4 458 296 (BRYANT et al.) ----- | | |

DOMAINES TECHNIQUES RECHERCHES (Int. Cl.4)

H 01 R
H 05 K

Le présent rapport a été établi pour toutes les revendications

| Lieu de la recherche | Date d'achèvement de la recherche | Examinateur |
|---|---|---|
| LA HAYE | 09-08-1988 | TOUSSAINT F.M.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)